(19) Europäisches Patentamt
European Patent Office
Office européen des brevets

(11) **EP 4 561 265 A1**

(12) **EUROPEAN PATENT APPLICATION**
published in accordance with Art. 153(4) EPC

(43) Date of publication:
**28.05.2025 Bulletin 2025/22**

(21) Application number: **23843432.8**

(22) Date of filing: **21.07.2023**

(51) International Patent Classification (IPC):
**H05B 45/50** (2022.01)    **H05B 45/345** (2020.01)

(52) Cooperative Patent Classification (CPC):
**H05B 45/345; H05B 45/50**

(86) International application number:
**PCT/KR2023/010579**

(87) International publication number:
**WO 2024/019586 (25.01.2024 Gazette 2024/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.07.2022 KR 20220091136**

(71) Applicant: **Seoul Viosys Co., Ltd.
Ansan-si, Gyeonggi-do 15429 (KR)**

(72) Inventors:
• **KWON, Ok Hwan
Ansan-Si Gyeonggi-do 15429 (KR)**
• **LIM, Kwang Bea
Ansan-Si Gyeonggi-do 15429 (KR)**

(74) Representative: **Stolmár & Partner
Patentanwälte PartG mbB
Blumenstraße 17
80331 München (DE)**

(54) **LED DRIVE MODULE**

(57) The present invention relates to an LED driving module. An LED driving module with an ultraviolet LED according to one embodiment of the present invention may include a fault sensing unit. The fault sensing unit may sense a fault of the ultraviolet LED. The fault sensing unit may include a connection sensing unit configured to sense a connection state of the ultraviolet LED. Further, the connection sensing unit may output a fault signal through the fault signal output terminal when a fault occurs in the ultraviolet LED due to short or opening of the ultraviolet LED.

【FIG. 1】

**Description**

[Technical Field]

The present invention relates to an LED driving module.

[Background Art]

With various advantages including small size, high luminous efficacy, long lifespan, and low manufacturing costs, light emitting diodes (LEDs) have replaced conventional light bulbs as means for lighting and display.
LEDs can be classified into infrared LEDs configured to emit infrared light, visible LEDs configured to emit visible light, and ultraviolet LEDs configured to emit ultraviolet light. Ultraviolet (UV) LEDs have been applied to a variety of products after it was found that UV light can kill DNA or RNA bacteria. In recent years, compact products employing a single light emitting diode have been developed in consideration of storage and portability.
Typically, such products may be provided with a separate light emitting diode and a driving module for driving the light emitting diode.
When a fault occurs in a product employing a light emitting diode, it is difficult to immediately determine whether the fault is caused by a fault of the light emitting diode or another component.

[Disclosure]

[Technical Problem]

It is one aspect of the present invention to provide an LED driving module configured to sense a faulty state of an ultraviolet LED and to output a fault signal to indicate a fault of the ultraviolet LED.
It is another aspect of the present invention to provide an LED driving module configured to output a fault signal based on which the type of fault that has occurred in the ultraviolet LED can be determined.
It is a further aspect of the present invention to provide an LED driving module that is suitable for small products to which a single ultraviolet LED is applied while detecting a fault of the ultraviolet LED.

[Technical Solution]

In accordance with one aspect of the present invention, there is provided an LED driving module provided with a single ultraviolet LED and including a fault sensing unit. The fault sensing unit may be configured to sense a fault of the ultraviolet LED. The fault sensing unit may include a connection sensing unit configured to sense a connection state of the ultraviolet LED. In addition, the connection sensing unit may output a fault signal through a fault signal output terminal when a fault occurs due to short or opening of the ultraviolet LED.
The connection sensing unit may include a connection sensing switch turned on and turned off corresponding to a voltage of a node connected to the ultraviolet LED.
The node connected to the ultraviolet LED may be connected to an anode terminal of the ultraviolet LED. In addition, the connection sensing switch may include a first end, a second end, and a third end through which signals are input or output. Here, a voltage corresponding to the voltage of the node may be applied to the first end to turn on and turn off the connection sensing switch. The second end may be connected to the fault signal output terminal. The third end may be connected to ground.
For example, the fault signal output terminal may include a first fault signal output terminal and a second fault signal output terminal. The first fault signal output terminal may output a first fault signal when the ultraviolet LED is in a short state. The second fault signal output terminal may output a second fault signal when the ultraviolet LED is in an open state.
The first fault signal output terminal may be connected to a node connecting the second end of the connection sensing switch and one end of a resistor. The second fault signal output terminal may be connected to a node connecting two resistors in series between the anode terminal of the ultraviolet LED and ground. The resistor connected to the second end of the connection sensing switch may be connected at the other end thereof to ground.
The fault sensing unit may further include a heat sensing unit configured to sense a heating state of the ultraviolet LED.
The heat sensing unit may include: a thermal resistor whose resistance varies depending on ambient temperature; and a heat sensing switch connected to the thermal resistor. The thermal resistor may be connected to the anode terminal of the ultraviolet LED. The heat sensing switch may be turned on and turned off in response to a voltage varying according to resistance of the thermal resistor.

The heat sensing switch may include a first end, a second end, and a third end through which signals are input or output. The first end may receive a voltage varying according to resistance of the thermal resistor. The second end may be connected to the fault signal output terminal. The third end may be connected to ground.

For example, the fault signal output terminal may include a first fault signal output terminal, a second fault signal output terminal, and a third fault signal output terminal. The first fault signal output terminal may output a first fault signal when the ultraviolet LED is in a short state. The second fault signal output terminal may output a second fault signal when the ultraviolet LED is in an open state. The third fault signal output terminal may output a third fault signal when the ultraviolet LED is in an overheating state.

The first fault signal output terminal may be connected to a node connecting the second end of the connection sensing switch to one end of a resistor. The second fault signal output terminal may be connected to a node connecting two resistors in series between the anode terminal of the ultraviolet LED and ground. The third fault signal output terminal may be connected to a node connecting the second end of the heat sensing switch to one end of a resistor. Each of the resistor connected to the second end of the connection sensing switch and the resistor connected to the second end of the heat sensing unit may be connected at the other end thereof to ground.

The connection sensing unit may include an opening sensing unit configured to sense an open state of the ultraviolet LED and a short sensing unit configured to sense a short state of the ultraviolet LED.

Each of the opening sensing unit and the short sensing unit may include an amplifier configured to compare a reference voltage with an input voltage and at least a switch turned on and off by an output signal of the amplifier.

The opening sensing unit may include an opening sensing switch. The opening sensing switch may include a first end, a second end, and a third end through which signals are input or output. The first end may receive a voltage for turning on and turning off the switch in response to a signal output from the amplifier of the opening sensing unit. The second end may be connected to the fault signal output terminal. The third end may allow a current input through the first end to pass therethrough when the opening sensing switch is in a turn-on state.

The short sensing unit may include a short sensing switch. The short sensing switch may include a first end, a second end, and a third end through which signals are input or output. The first end may receive a voltage for turning on and turning off the switch in response to a signal output from an amplifier of the short sensing unit. The second end may be connected to the fault signal output terminal. The third end may allow a current input through the first end to pass therethrough when the short sensing switch is in a turn-on state.

The fault signal output terminal may output a normal signal when the ultraviolet LED is in a normal state.

The fault signal may be a lower voltage than the normal signal.

The LED driving module may further include a Zener diode connected at one end thereof to the fault signal output terminal and at the other end thereof to ground. Here, the normal signal may be a Zener voltage.

The LED driving module may further include a current sensing unit and a control signal generator. The current sensing unit may be configured to sense a current supplied to the ultraviolet LED. The control signal generator may be configured to generate and output a signal to control a switch according to a current value sensed by the current sensing unit. The control signal generator may output a short signal to the switch to turn on the switch and an open signal to turn off the switch. The connection sensing unit may sense the short signal and the open signal output from the control signal generator to the switch. Here, the fault sensing unit may generate and output a fault signal when the short signal or the open signal sensed by the connection sensing unit is sensed for a preset period of time or more.

The fault sensing unit may further include a heat sensing unit configured to sense a temperature of the ultraviolet LED or an ambient temperature of the ultraviolet LED. The fault sensing unit may generate and output a fault signal when the temperature sensed by the heat sensing unit is greater than or equal to a preset temperature.

The LED driving module may further include a constant current unit configured to supply a constant current to the ultraviolet LED.

[Advantageous Effects]

According to embodiments of the present invention, an LED driving module configured to sense a faulty state of a UV LED can determine whether a fault occurs in the UV LED.

In addition, according to the embodiments, the LED driving module outputs a signal according to the type of failure that has occurred in the UV LED, whereby a faulty state of the UV LED can be accurately identified.

Further, according to the embodiments, the LED driving module may be suitable for small products by realizing a simple circuit configured to sense a fault of the LED to minimize increase in size thereof.

[Description of Drawings]

FIG. 1 is a schematic block diagram of an LED driving module according to a first embodiment of the present invention.

FIG. 2 is a block diagram of the LED driving module according to the first embodiment of the present invention.

FIG. 3 is a circuit diagram of a fault sensing unit of the LED driving module according to the first embodiment of the present invention.

FIG. 4 is a block diagram illustrating functions of an LED driving module according to a second embodiment of the present invention.

FIG. 5 is a circuit diagram of the LED driving module according to the second embodiment of the present invention.

FIG. 6 is a schematic block diagram of an LED driving module according to a third embodiment of the present invention.

FIG. 7 is a circuit diagram of an LED driving module according to a fourth embodiment of the present invention.

FIG. 8 is a block diagram of an LED driving module according to a fifth embodiment of the present invention.

FIG. 9 is a schematic block diagram of a system of an ultraviolet LED device according to one embodiment of the present invention.

FIG. 10 is a schematic block diagram of a system of an ultraviolet LED device according to another embodiment of the present invention.

[Best Mode]

Hereinafter, embodiments of the present invention will be described with reference to the accompanying drawings. It should be understood that the following embodiments are provided for complete disclosure and thorough understanding of the present invention by those skilled in the art. Accordingly, the present invention is not limited to the following embodiments and may be embodied in different ways. In addition, the drawings may be exaggerated in width, length, and thickness of components for descriptive convenience and clarity only. Like components will be denoted by like reference numerals throughout the specification.

Hereinafter, an LED driving module according to the present invention will be described in detail with reference to the drawings.

LED driving modules according to embodiments of the present invention are applied to small products employing ultraviolet LEDs. The LED driving modules according to the embodiments of the present invention may sense a fault of an ultraviolet LED, and generate and output a fault signal. More specifically, the LED driving modules may output a normal signal indicating a normal state and a fault signal indicating a faulty state depending on the state of the ultraviolet LED. Hereinafter, description of various embodiments of the present invention with reference to the drawings will focus on a fault sensing unit configured to sense a fault of the ultraviolet LED.

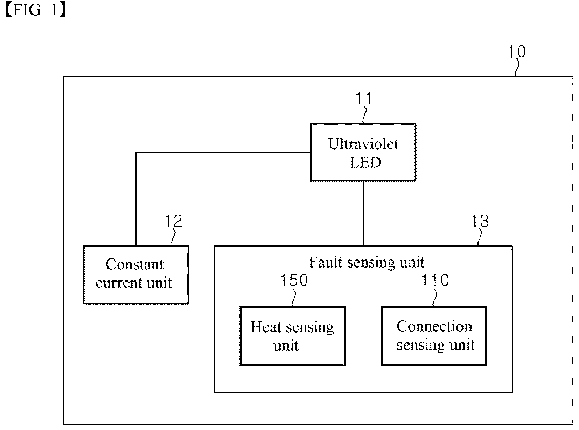

FIG. 1 to FIG. 3 are views of an LED driving module according to a first embodiment of the present invention.

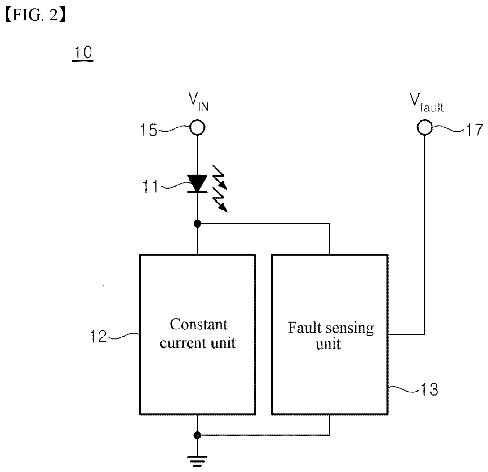

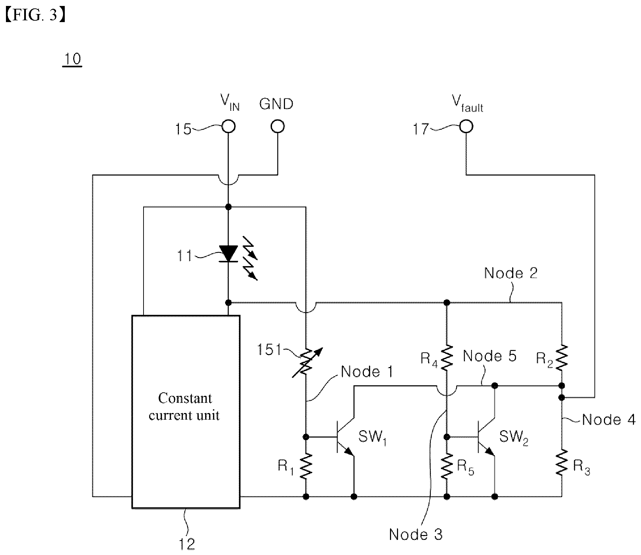

FIG. 1 is a schematic block diagram of an LED driving module according to a first embodiment of the present invention. FIG. 2 is a schematic block diagram of the LED driving module according to the first embodiment of the present invention. FIG. 3 is a circuit diagram of a fault sensing unit of the LED driving module according to the first embodiment of the present invention.

Referring to FIG. 1 to FIG. 3, the LED driving module 10 according to the first embodiment of the present invention may include an ultraviolet LED 11, a constant current unit 12, and a fault sensing unit 13. Referring to FIG. 2, in the LED driving module 10 according to the first embodiment, the constant current unit 12 may be disposed at the rear end of the ultraviolet LED 11. That is, in the LED driving module 10 according to the first embodiment, the constant current unit 12 may be connected to a cathode terminal of the ultraviolet LED 11 to control a current flowing in the ultraviolet LED 11.

The LED driving module 10 according to this embodiment is a module to be applied to small products and may include one ultraviolet LED 11.

The constant current unit 12 enables a constant current to flow in the ultraviolet LED 11 when the ultraviolet LED 11 is turned on. The constant current unit 12 may control the current flowing in the ultraviolet LED 11 to be constant such that the intensity of UV light emitted from the ultraviolet LED 11 is constant.

The constant current unit 12 may be realized as a circuit of various structures using resistors, transistors, diodes, Zener diodes, and the like. The constant current unit 12 according to this embodiment may include any of constant current circuits known to those skilled in the art.

The fault sensing unit 13 may be configured to sense a fault that has occurred in the ultraviolet LED 11.

According to this embodiment, the fault sensing unit 13 may include a connection sensing unit 110 and a heat sensing unit 150.

The connection sensing unit 110 may be configured to sense an abnormality in a connection state of the ultraviolet LED 11. That is, the connection sensing unit 110 may be configured to sense failure of the connection state, such as opening and short circuit of the ultraviolet LED 11.

The heat sensing unit 150 may be configured to sense a heating state of the ultraviolet LED 11 by detecting an ambient temperature. When the ultraviolet LED 11 emits UV light, the ultraviolet LED 11 may generate heat due to various causes, such as contact between a semiconductor and a metal, lattice vibration (phonon), heat conversion of light reabsorbed by total reflection from the surface, leakage current, and the like. When the ultraviolet LED 11 emits heat, the ambient temperature of the ultraviolet LED 11 increases. When the ambient temperature of the ultraviolet LED 11 increases, the ambient temperature of other devices including the LED driving module 10 also increases. That is, the heat sensing unit 150 can detect a fault of the ultraviolet LED 11 by sensing a change in ambient temperature.

As such, the fault sensing unit 13 may sense a heating state and the connection state between the anode terminal and the cathode terminal of the ultraviolet LED 11 and may output a fault signal indicating an abnormal state when the abnormal state is sensed. Further, the fault sensing unit 13 may output a normal signal indicating a normal state of the ultraviolet LED 11 when no fault of the ultraviolet LED 11 is sensed.

Referring to FIG. 2, the LED driving module 10 may include an input terminal 15 that receives signals from the outside and a fault signal output terminal 17 that outputs signals to the outside. According to this embodiment, a driving voltage is supplied to the ultraviolet LED 11 through the input terminal 15. In addition, a fault signal indicating a fault state of the ultraviolet LED 11 may be output through the fault signal output terminal 17. In addition, a normal signal indicating a normal state of the ultraviolet LED 11 may be output through the fault signal output terminal 17.

The constant current unit 12 may be disposed at the rear end of the ultraviolet LED 11. That is, the constant current unit 12 may be connected to the cathode terminal of the ultraviolet LED 11. In addition, the fault sensing unit 13 may also be disposed at the rear end of the ultraviolet LED 11 and may be connected to the cathode terminal of the ultraviolet LED 11.

FIG. 3 is a circuit diagram of the LED driving module 10. Referring to FIG. 3, the circuit constituting the fault sensing unit 13 of the LED driving module 10 may include switches each provided with a plurality of terminals through which signals are input or output. In this embodiment, the switches may be NPN-type bipolar transistors. When the switches are the bipolar transistors, each of the switches may include three terminals through which signals are input or output. For example, the switch may include a first end as a base terminal, a second end as a collector terminal, and a third end as an emitter terminal. Further, the signals input to the switch may be a voltage and a current.

The heat sensing unit 150 according to this embodiment may include a thermal resistor 151, a first switch $SW_1$, and a first resistor $R_1$.

The thermal resistor 151 refers to a device whose resistance value changes with change in temperature. For example, the thermal resistor 151 may be a negative temperature coefficient (NTC) thermistor that has characteristics of a negative resistance temperature coefficient, in which the resistance decreases when the temperature increases. That is, according to this embodiment, when the temperature around the thermal resistor 151 is higher than or equal to a certain temperature, the resistance value of the thermal resistor 151 decreases.

The thermal resistor 151 may be connected at a first end thereof to the anode terminal of the ultraviolet LED 11 and connected at a second end thereof to a first end of the first resistor $R_1$.

The first switch $SW_1$ may be connected at a first end thereof to a first node (Node 1) to which the second end of the thermal resistor 151 and the first end of the first resistor $R_1$ are connected. In addition, the first switch $SW_1$ may be connected at a second end thereof to a second end of the second switch $SW_2$. Further, the second end of the first switch $SW_1$ may be connected to the fault signal output terminal 17 that is an output terminal of the fault sensing unit 13.

In addition, a second end of the first resistor $R_1$ and a third end of the first switch $SW_1$ may be connected to ground.

According to this embodiment, the connection sensing unit 110 may include a second switch $SW_2$, a second resistor $R_2$, a third resistor $R_3$, and a fifth resistor $R_5$.

The second resistor $R_2$ may be connected at a first end thereof to the cathode terminal of the ultraviolet LED 11 and connected at a second end thereof to a first end of the third resistor $R_3$. That is, the second resistor $R_2$ and the third resistor $R_3$ may be connected in series.

A fourth resistor $R_4$ may be connected at a first end thereof to the cathode terminal of the ultraviolet LED 11. That is, the first end of the fourth resistor $R_4$ may be connected to a second node (Node 2) to which the cathode terminal of the ultraviolet LED 11 and the first end of the second resistor $R_2$ are connected. In addition, the fourth resistor $R_4$ may be connected at a second end thereof to a first end of the fifth resistor $R_5$. That is, the fourth resistor $R_4$ and the fifth resistor $R_5$ may be connected in series. In addition, the fourth resistor $R_4$ and the fifth resistor $R_5$ may be connected in parallel to the second resistor $R_2$ and the third resistor $R_3$.

The second switch $SW_2$ may be connected at a first end thereof to a third node (Node 3), to which the second end of the fourth resistor $R_4$ and the first end of the fifth resistor $R_5$ are connected. In addition, the second switch $SW_2$ may be connected at a second end thereof to a fourth node (Node 4) to which the second resistor $R_2$ and the third resistor $R_3$ are connected, and to a fifth node (Node 5) to which the second end of the first switch $SW_1$ is connected. That is, the second end of the second switch $SW_2$ may be connected to the fault signal output terminal 17 of the fault sensing unit 13.

A second end of the fifth resistor $R_5$, a third end of the second switch $SW_2$, and a second end of the third resistor $R_3$ may be connected to ground.

In the fault sensing unit 13 according to this embodiment, the heat sensing unit 150 and the connection sensing unit 110 may be connected to the fault signal output terminal 17. That is, the fault sensing unit 13 may be formed such that the heat sensing unit 150 and the connection sensing unit 110 share the same fault signal output terminal 17. Thus, the fault sensing unit 13 may output a fault signal when any of a fault caused by heat generation of the ultraviolet LED 11 and a fault caused by the connection state is sensed.

According to this embodiment, the fault sensing unit 13 may allow a voltage at the fault signal output terminal 17 to become 0 V when the ultraviolet LED 11 fails due to heat generation or the connection state. That is, the fault sensing unit 13 of the LED driving module 10 according to this embodiment may be designed such that 0 V output from the fault signal output terminal 17 becomes a fault signal indicating a fault of the ultraviolet LED 11.

When the ultraviolet LED 11 generates heat, the ambient temperature of the ultraviolet LED 11 increases. Since the LED driving module 10 according to this embodiment is a compact device, the ambient temperature of the thermal resistor 151 also increases due to heat generation of the ultraviolet LED 11. Accordingly, the heat sensing unit 150 according to this embodiment can sense the degree of heat generation from the ultraviolet LED 11 based on the ambient temperature sensed by the thermal resistor 151.

For example, the thermal resistor 151 of the heat sensing unit 150 may decrease in resistance when the ambient temperature increases. In addition, a voltage distributed by the thermal resistor 151 and the first resistor $R_1$ may be applied to the first end of the first switch $SW_1$. When the resistance value of the thermal resistor 151 decreases due to increase in ambient temperature, the voltage applied to the first end of the first switch $SW_1$ also increases.

When a voltage higher than a preset operation voltage of the first switch $SW_1$ is applied to the first end of the first switch $SW_1$, the first switch $SW_1$ may be turned on. Here, the operation voltage refers to a reference voltage at which the first switch $SW_1$ is turned on or turned off. As such, in this embodiment, the operation voltage may be a reference for distinguishing between normal heating and abnormal overheating of the ultraviolet LED 11. For example, the operation voltage of the switches may be set as a threshold voltage. The first switch $SW_1$ of the heat sensing unit 150 is a heat sensing switch that operates according to the heating temperature of the ultraviolet LED 11.

When the first switch $SW_1$ is turned on, a current flowing through the fourth node (Node 4) may pass through the first switch $SW_1$ and the voltage at the fault signal output terminal 17 may become 0 V.

As such, the heat sensing unit 150 according to this embodiment may generate a fault signal indicating a fault of the ultraviolet LED 11 by allowing the first switch SW1 to be turned on when the ambient temperature is increased above a certain temperature by the ultraviolet LED 11. Here, the certain temperature refers to a reference temperature with respect to an overheating state that occurs when the ultraviolet LED 11 is abnormal.

When the ultraviolet LED 11 is in a normal heating state, a voltage to maintain the first switch SW1 in a turn-off state is applied to the first end of the first switch SW1. That is, when the ultraviolet LED 11 is in a normal heating state, the first switch $SW_1$ is kept in the turn-off state.

According to this embodiment, the connection sensing unit 110 may sense a fault caused by the connection state of the ultraviolet LED 11. That is, the connection sensing unit 110 may sense short circuit and opening of the ultraviolet LED 11.

The connection sensing unit 110 may allow the voltage at the fault signal output terminal 17 to become 0 V when the ultraviolet LED 11 is in a short state.

The second switch $SW_2$ is connected at the first end thereof to the third node (Node 3). Thus, the second switch $SW_2$ may be turned on or off depending on the voltage at the third node (Node 3).

For example, the second switch $SW_2$ may be in a turn-off state when the voltage at the first end thereof is less than a preset operation voltage. In addition, the second switch $SW_2$ may be turned on when the voltage at the first end thereof is greater than or equal to the preset operation voltage. As such, the preset operation voltage may become a reference for defining a short state of the ultraviolet LED 11. The operation voltage may be a threshold voltage of the second switch $SW_2$. The second switch $SW_2$ is a connection sensing switch that operates according to the connection state of the ultraviolet LED 11.

When the ultraviolet LED 11 is in a normal state, the second node (Node 2) has a voltage corresponding to a voltage drop from a driving voltage to the operation voltage of the ultraviolet LED 11. When the ultraviolet LED 11 is in a normal state, a voltage smaller than the preset operation voltage may be applied to the first end of the second switch $SW_2$. Here, the second switch $SW_2$ may be kept in a turn-off state.

When the second switch $SW_2$ is kept in a turn-off state, a current flows through the fourth node (Node 4) connecting the second resistor $R_2$ to the third resistor $R_3$. Here, the fault signal output terminal 17 may output a voltage distributed by the second resistor $R_2$ and the third resistor $R_3$. For example, when the ultraviolet LED 11 is in a normal state, the voltage at the fault signal output terminal 17 may be calculated according to Equation 1.

[Equation 1]

$$V_{fault} = (V_{IN} - V_{LED}) \cdot (R_3/(R_2+R_3))$$

Here, $V_{fault}$ denotes a voltage output from the fault signal output terminal 17 and corresponds to a fault signal. $V_{IN}$

denotes a driving voltage supplied through the input terminal 15, $V_{LED}$ denotes the operation voltage of the ultraviolet LED, $R_2$ denotes the second resistor, and $R_3$ denotes the third resistor.

When the ultraviolet LED 11 is in a short state, the voltage at the second node 2 may be the same as the driving voltage. That is, when the ultraviolet LED 11 is in a short state, a higher voltage is applied to the second node 2 than when the ultraviolet LED 11 is in a normal state. Then, the second switch $SW_2$ may be turned on by a voltage at the first end thereof, which is higher than or equal to the operation voltage.

When the second switch $SW_2$ is turned on, the current flows to ground through the second resistor $R_2$ and the second switch $SW_2$ and the voltage at the fault signal output terminal 17 may become 0 V.

In addition, when the ultraviolet LED 11 is in an open state, the voltage at the second node 2 is 0 V. Accordingly, the voltage at the fault signal output terminal 17 may become 0 V.

When the ultraviolet LED 11 is in a short state and in an open state, the connection sensing unit 110 may output 0 V corresponding to a fault signal to the fault signal output terminal 17.

As such, the LED driving module 10 according to this embodiment may output a normal signal corresponding to a voltage of $(V_{IN} - V_{LED})(R_1/(R_1 + R_2))$ to the fault signal output terminal 17 when the ultraviolet LED 11 is normal both in heat generation and connection thereof. Further, the LED driving module 10 may output a fault signal corresponding to a voltage of 0 V to the fault signal output terminal 17 when the ultraviolet LED 11 is in any one state among a short state, an open state, and an abnormal heating state.

The fault sensing unit 13 of the LED driving module 10 according to this embodiment allows 0 V to be output from the fault signal output terminal 17 when a fault occurs in the ultraviolet LED 11, but is not limited thereto. For example, the fault sensing unit 13 may include a circuit adapted to output an arbitrary voltage other than 0 V as a fault signal. That is, the fault signal of the fault sensing unit 13 may be a preset voltage output when a fault occurs in the ultraviolet LED 11. Here, the fault sensing unit 13 may output a normal signal distinguished from the fault signal when the ultraviolet LED 11 is in a normal state. That is, the fault sensing unit 13 of the LED driving module 10 according to this embodiment may be configured with a circuit capable of outputting signals that can distinguish between when the ultraviolet LED 11 is in a normal state and when the ultraviolet LED 11 is in a faulty state.

As such, the LED driving module 10 according to this embodiment includes the fault sensing unit 13 that outputs a signal capable of distinguishing between when the ultraviolet LED 11 is in a normal state and when the ultraviolet LED 11 is in a faulty state. Thus, when a fault occurs in a product employing the LED driving module 10, it is possible to distinguish whether the fault is caused by the ultraviolet LED 11 or by other components. Accordingly, when a signal indicating a fault of the ultraviolet LED 11 is output, it is possible to easily solve a problem of a defective product by replacing the ultraviolet LED 11 without checking whether the other components are defective.

In this embodiment, the thermal resistor 151 is described as an NTC by way of example. However, the heat sensing unit 150 according to this embodiment is not limited thereto. For example, the thermal resistor 151 of the heat sensing unit 150 may be a positive temperature coefficient (PTC) thermistor having characteristics of a constant resistance temperature coefficient such that the resistance value increases as the temperature increases. Here, the first switch SW1 of the heat sensing unit 150 may be set to be turned on at a preset operation voltage or less.

In the LED driving module 10 according to this embodiment, the switches in the fault sensing unit 13 are described as NPN type bipolar transistors by way of example. However, it should be understood that the type of switches applied to this embodiment is not limited to the NPN type bipolar transistor. For example, the switches of the fault sensing unit 13 may be configured with diodes or MOSFETs. Alternatively, the switches may be transistors that are turned on at a lower voltage than the operation voltage or threshold voltage. As such, the switches may be any devices that are turned on or off in response to an input signal.

As such, the fault sensing unit 13 according to this embodiment may be implemented in various ways so long as the fault sensing unit is capable of sensing a normal state and a faulty state of the ultraviolet LED 11 and outputting a signal capable of distinguishing the normal state and the faulty state.

The LED driving module 10 according to this embodiment may be applied to a small product employing a single UV LED 11. As the demand for small products increases, the LED driving module 10 according to this embodiment also maintains the size for small products. Furthermore, the LED driving module 10 according to this embodiment includes the fault sensing unit 13 configured to sense an abnormality of the ultraviolet LED 11 and to generate a signal corresponding to the abnormality.

The LED driving module 10 according to this embodiment is realized to sense a fault of the ultraviolet LED 11 through a simple circuit. Accordingly, the LED driving module 10 according to this embodiment can sense a fault of the ultraviolet LED 11 and output a signal indicating the fault while maintaining the size of a conventional LED driving module.

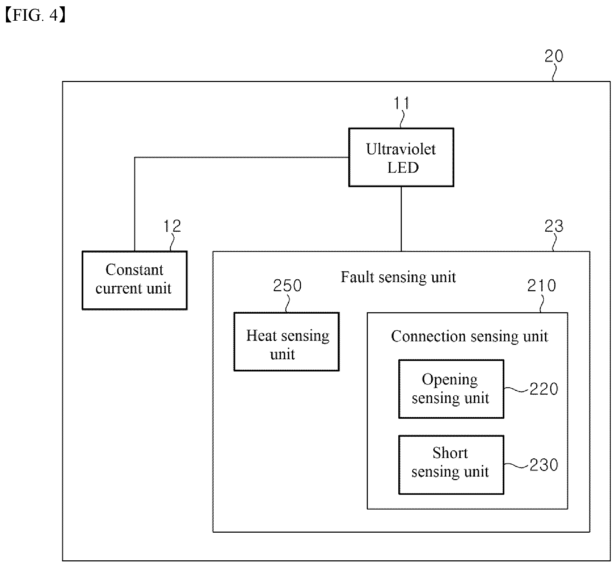

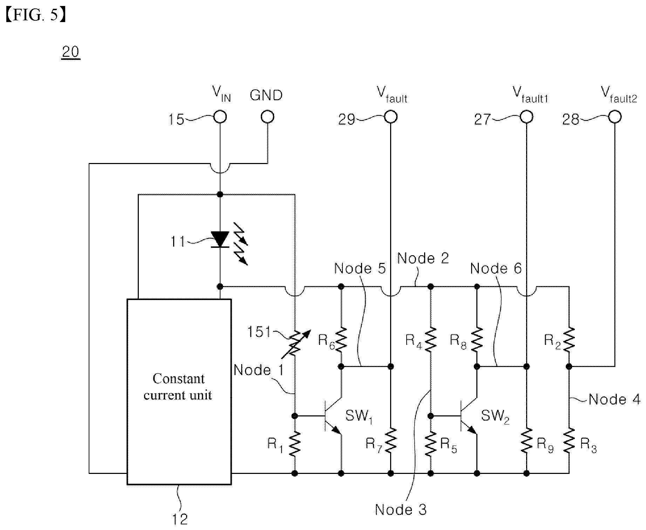

FIG. 4 and FIG. 5 are views of an LED driving module according to a second embodiment of the present invention.

FIG. 4 is a block diagram illustrating functions of the LED driving module according to the second embodiment. FIG. 5 is a schematic diagram of the LED driving module according to the second embodiment.

Referring to FIG. 4 and FIG. 5, the LED driving module 20 according to the second embodiment includes a constant current unit 12 and a fault sensing unit 23.

The fault sensing unit 23 according to this embodiment may include a heat sensing unit 250 and a connection sensing unit 210. The connection sensing unit 210 according to this embodiment includes an opening sensing unit 220 and a short sensing unit 230.

The fault sensing unit 23 according to this embodiment may output signals through the heat sensing unit 250, the opening sensing unit 220, and the short sensing unit 230, respectively. That is, the fault sensing unit 23 may sense a faulty state of the ultraviolet LED 11 and may output a signal capable of distinguishing the type of fault sensed.

Referring to FIG. 5, the fault sensing unit 23 according to this embodiment may be configured to sense a heating state, a short state, and an open state of the ultraviolet LED 11 and to output a signal corresponding to each state.

The heat sensing unit 250 according to this embodiment may include a thermal resistor 151, a first switch $SW_1$, a first resistor $R_1$, a sixth resistor $R_6$, and a seventh resistor $R_7$.

The thermal resistor 151 may be connected at a first end thereof to the anode terminal of the ultraviolet LED 11 and connected at a second end thereof to a first end of the first resistor $R_1$. The thermal resistor 151 and the first resistor $R_1$ may be connected to each other in series.

The sixth resistor $R_6$ may be connected at a first end thereof to the cathode terminal of the ultraviolet LED 11 and connected at a second end thereof to a second end of the first switch $SW_1$.

The first switch $SW_1$ may be connected at a first end thereof to a first node (Node 1) to which the thermal resistor 151 and the first resistor $R_1$ are connected, and may be connected at a second end thereof to a second end of the sixth resistor $R_6$.

The seventh resistor $R_7$ may be connected at a first end thereof to the second end of the first switch $SW_1$ and may be connected to the first switch $SW_1$ in parallel.

In the heat sensing unit 250, a second end of the first resistor $R_1$, a third end of the first switch $SW_1$ and a second end of the seventh resistor $R_7$ may be connected to ground.

The heat sensing unit 250 may output a third fault signal and a normal signal through a node to which the first switch $SW_1$ and the seventh resistor $R_7$ are connected. That is, the heat sensing unit 250 may be formed with a third fault signal output terminal 29 that outputs a signal regarding a heating state of the ultraviolet LED 11 to a fifth node (Node 5) to which the second end of the first switch $SW_1$ and the third resistor $R_3$ are connected.

The connection sensing unit 210 according to this embodiment may include a second resistor $R_2$, a third resistor $R_3$, a fourth resistor $R_4$, a fifth resistor $R_5$, an eighth resistor $R_8$, a ninth resistor $R_9$, and a second switch $SW_2$.

The second resistor $R_2$ may be connected at a first end thereof to the cathode terminal of the ultraviolet LED 11. In addition, each of the fourth resistor $R_4$ and the eighth resistor $R_8$ may be connected at a first end thereof to a second node (Node 2) to which the cathode terminal of the ultraviolet LED 11 and the second resistor $R_2$ are connected.

The second resistor $R_2$ may be connected at a second end thereof to a first end of the third resistor $R_3$. The fourth resistor $R_4$ may be connected at a second end thereof to a first end of the fifth resistor $R_5$. In addition, the eighth resistor $R_8$ may be connected at a second end thereof to a second end of the second switch $SW_2$. Here, a second end of the third resistor $R_3$, a second end of the fifth resistor $R_5$, and a third end of the second switch $SW_2$ may be connected to ground. In addition, the second switch $SW_2$ may be connected at a first end thereof to a third node (Node 3) to which the fourth resistor $R_4$ and the fifth resistor $R_5$ are connected.

The connection sensing unit 210 according to this embodiment may output a first fault signal indicating an abnormal connection state of the ultraviolet LED 11 through a sixth node (Node 6) to which the second end of the second switch $SW_2$ and the ninth resistor $R_9$ are connected. That is, a first fault signal output terminal 27 may be formed at the node to which the second end of the second switch $SW_2$ and the ninth resistor $R_9$ are connected.

Further, the connection sensing unit 210 according to this embodiment may output a second fault signal indicating an abnormal connection state of the ultraviolet LED 11 through a fourth node (Node 4) to which the second resistor $R_2$ and the third resistor $R_3$ are connected. That is, a second fault signal output terminal 28 may be formed at the node to which the second resistor $R_2$ and the third resistor $R_3$ are connected.

In the block diagram of FIG. 4, although the short sensing unit 230 and the opening sensing unit 220 are shown as separate configurations, these configurations are provided to distinguish the functions of the connection sensing unit 210. That is, the connection sensing unit 210 may output signals corresponding to the open state and the short state of the ultraviolet LED 11 according to operation of one switch, as shown in FIG. 5.

When the heating state of the ultraviolet LED 11 is normal, the ambient temperature of the thermal resistor 151 may also be within a normal temperature range. When the ambient temperature of the thermal resistor 151 is normal, a voltage is applied to the first end of the first switch $SW_1$ such that the first switch $SW_1$ can be kept in a turn-off state. When the first switch $SW_1$ is in the turn-off state, a current flows in the sixth resistor $R_6$ and the seventh resistor $R_7$. Thus, when the heating state of the ultraviolet LED 11 is normal, a normal signal, which is a certain voltage applied to the fifth node (Node 5), may be output from the third fault signal output terminal 29. In this embodiment, the voltage that is a normal signal output from the third fault signal output terminal 29 may be determined by the voltage of the second node 2, the sixth resistor $R_6$, and the seventh resistor $R_7$.

When the ambient temperature of the thermal resistor 151 increases such that the voltage applied to the first end of the first switch $SW_1$ is higher than or equal to a preset operation voltage, the first switch $SW_1$ may be turned on. When the first switch $SW_1$ is turned on, a current may flow through the sixth resistor $R_6$ and the first switch $SW_1$, and the voltage at the fifth node 5 may become 0 V. That is, when the ultraviolet LED 11 is in an overheating state outside the normal range, the heat sensing unit 250 may output 0 V as a third fault signal through the third fault signal output terminal 29.

The heat sensing unit 250 according to this embodiment may detect an overheating state of the ultraviolet LED 11 regardless of the connection state of the ultraviolet LED 11. That is, when the ultraviolet LED 11 is in an abnormal overheating state, a third fault signal is output from the third fault signal output terminal 29.

When the ultraviolet LED 11 operates in a normal connection state, the second node (Node 2) has a voltage corresponding to a voltage drop from a driving voltage to the operation voltage of the ultraviolet LED 11. Here, a low voltage may be applied to the first end of the second switch $SW_2$ to maintain the turn-off state of the second switch $SW_2$. That is, when the ultraviolet LED 11 is in the normal connection state, the second switch $SW_2$ may be kept in the turn-off state.

When the second switch $SW_2$ is in the turn-off state, a current flows through the node 6 to which the eighth resistor $R_8$ and the ninth resistor $R_9$ are connected. Here, a signal output from the first fault signal output terminal 27 may be any voltage greater than 0 V.

In addition, when the second switch $SW_2$ is in the turn-off state, a current flows through the fourth node (Node 4) to which the second resistor $R_2$ and the third resistor $R_3$ are connected. Here, a signal output from the second fault signal output terminal 28 may be any voltage greater than 0 V.

As such, when the connection state of the ultraviolet LED 11 is normal, the connection sensing unit 210 according to this embodiment may output normal signals, which are any voltages greater than 0 V, through the first fault signal output terminal 27 and the second fault signal output terminal 28, respectively.

The second node (Node 2) has a greater voltage when the ultraviolet LED 11 is in a short state than when the ultraviolet LED 11 is in a normal state. For example, when the ultraviolet LED 11 is in a short state, the voltage at second node (Node 2) may be the same as the driving voltage. As the voltage at the second node (Node 2) increases, the voltage applied to the first end of the second switch $SW_2$ also increases. When a voltage greater than the operation voltage of the second switch $SW_2$ is applied to the first end of the second switch $SW_2$, the second switch $SW_2$ may be turned on.

When the second switch $SW_2$ is turned on, the current having passed through the eighth resistor $R_8$ passes through the second switch $SW_2$ and the voltage of the first fault signal output from the sixth node (Node 6) may become 0 V. Accordingly, the first fault signal output terminal 27 may output the first fault signal that is 0 V.

A current may flow in the fourth node (Node 4) to which the second resistor $R_2$ and the third resistor $R_3$ are connected. Here, the voltage at the fourth node (Node 4) may be any voltage greater than 0 V due to the voltage at the second node (Node 2), the second resistor $R_2$, and the third resistor $R_3$. Thus, the second fault signal output terminal 28 may output a normal signal that is a certain voltage greater than 0 V. According to this embodiment, this voltage may be set by the resistors and switches constituting the circuit.

As such, the fault sensing unit 23 according to this embodiment may output a first fault signal through the first fault signal output terminal 27 and a normal signal through the second fault signal output terminal 28 when the ultraviolet LED 11 is in a short state.

When the ultraviolet LED 11 is in an open state, the voltage at the second node (Node 2) may be much smaller than when the ultraviolet LED 11 is in a normal state. For example, when the ultraviolet LED 11 is in an open state, the voltage at second node (Node 2) may be 0 V.

Since the voltage at the second node (Node 2) is 0 V, the voltages at the fourth node (Node 4) and the sixth node (Node 6) may also be 0 V. Therefore, a first fault signal and a second fault signal, which are 0 V, may be output from the first fault signal output terminal 27 and the second fault signal output terminal 28, respectively.

As such, the fault sensing unit 23 according to this embodiment may output the first fault signal through the first fault signal output terminal 27 and the second fault signal through the second fault signal output terminal 28 when the ultraviolet LED 11 is in an open state.

Table 1 shows signals output from the fault sensing unit 23 according to the state of the ultraviolet LED 11.

Table 1

| Temperature state | Connection state | First fault signal output terminal | Second fault signal output terminal | Third fault signal output terminal |
|---|---|---|---|---|
| Normal | Normal | Normal signal | Normal signal | Normal signal |
| Normal | Short | First fault signal | Normal signal | Normal signal |
| Normal | Open | First fault signal | Second fault signal | Normal signal |
| Abnormal heating | Normal | Normal signal | Normal signal | Third fault signal |
| Abnormal heating | Short | First fault signal | Normal signal | Third fault signal |

(continued)

| Temperature state | Connection state | First fault signal output terminal | Second fault signal output terminal | Third fault signal output terminal |
|---|---|---|---|---|
| Abnormal heating | Open | First fault signal | Second fault signal | Third fault signal |

In the LED driving module 20 according to the embodiment of the present invention, the fault sensing unit 23 may output a normal signal or a fault signal through the first fault signal output terminal 27, the second fault signal output terminal 28, and the third fault signal output terminal 29 depending on the faulty state of the ultraviolet LED 11. Accordingly, it is possible to determine not only a fault of the ultraviolet LED 11, but also the type of fault that has occurred in the ultraviolet LED 11 depending upon combination of signals output from the first fault signal output terminal 27, the second fault signal output terminal 28, and the third fault signal output terminal 29.

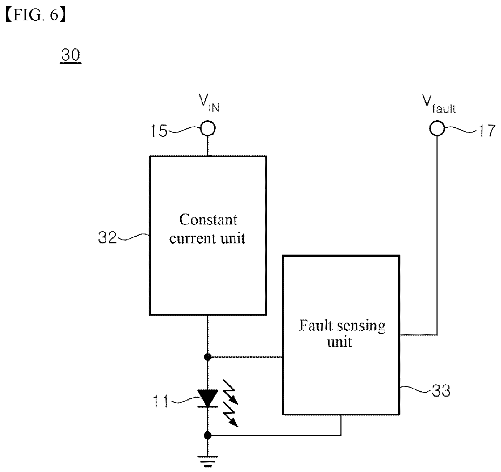

FIG. 6 is a schematic block diagram of an LED driving module according to a third embodiment of the present invention.

The LED driving module 10 according to the third embodiment may include an ultraviolet LED 11, a constant current unit 12, and a fault sensing unit 33.

Referring to FIG. 6, in the LED driving module 10 according to the third embodiment, the constant current unit 12 may be disposed at the front end of the ultraviolet LED 11. That is, the constant current unit 12 may be connected to a node between an input terminal to which a voltage is input and an anode terminal of the ultraviolet LED 11 and may control a current flowing in the ultraviolet LED 11.

The constant current unit 12 according to this embodiment may be realized by any circuit that is disposed at the front end of the ultraviolet LED 11 and may control the current of the ultraviolet LED 11.

In addition, the fault sensing unit 33 according to this embodiment may be configured with the circuit of the fault sensing unit 13 of the LED driving module 10 according to the first embodiment shown in FIG. 3 or the circuit of the fault sensing unit 23 of the LED driving module 20 according to the second embodiment shown in FIG. 5.

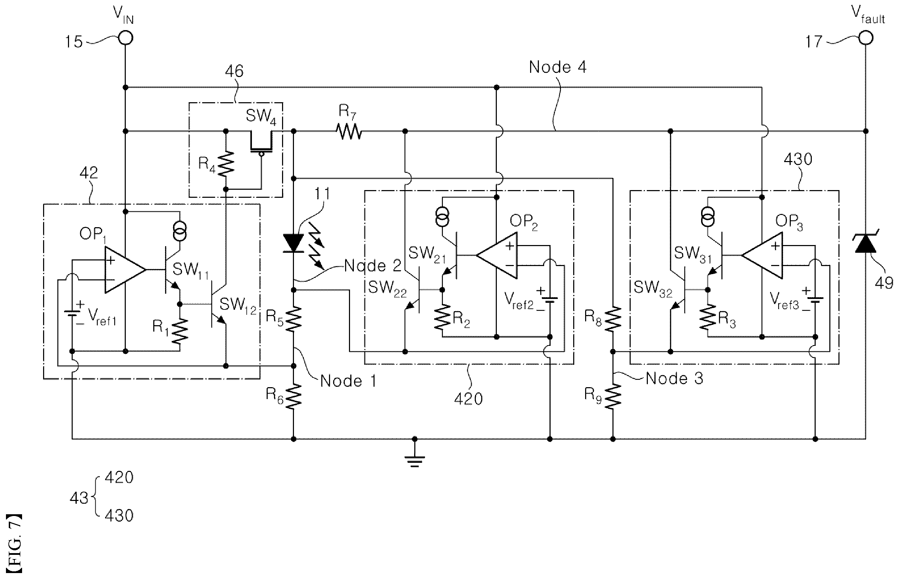

FIG. 7 is a circuit diagram of an LED driving module according to a fourth embodiment of the present invention.

Referring to FIG. 7, in the LED driving module 40 according to the fourth embodiment, a constant current unit 42 may be disposed at the front end of the ultraviolet LED 11.

The LED driving module 40 according to the fourth embodiment may include an ultraviolet LED 11, the constant current unit 42, a switch unit 46, and a fault sensing unit 43. In this embodiment, the fault sensing unit 43 may be a connection sensing unit. The fault sensing unit 43 may include an opening sensing unit 420 and a short sensing unit 430.

The constant current unit 42 according to this embodiment may control the switch unit 46 to supply a constant current to the ultraviolet LED 11. The switch unit 46 according to this embodiment may include a fourth switch $SW_4$ and a fourth resistor $R_4$. The fourth switch $SW_4$ may be a p-type MOSFET.

In the LED driving module 40 according to this embodiment, the opening sensing unit 420 and the short sensing unit 430 do not operate when the ultraviolet LED 11 is in a normal state. Further, in the LED driving module 40 according to this embodiment, the opening sensing unit 420 may operate when the ultraviolet LED 11 is in an open state and the short sensing unit 430 may operate when the ultraviolet LED 11 is in a short state.

Each of the constant current unit 42, the opening sensing unit 420, and the short sensing unit 430 according to this embodiment may include an amplifier, switches, and resistors.

Each of the amplifiers may be a negative feedback amplifier. In addition, a preset reference voltage and an input voltage may input to each of the amplifiers. Each of the amplifiers may compare an input voltage with an incoming reference voltage and may control a switch connected to the amplifier based on a comparison result. The amplifier may allow an output terminal to output a voltage depending upon the state of the ultraviolet LED 11 by controlling the switch.

Each of the switches may be an NPN-type bipolar transistor. The switch realized by the bipolar transistor may include a first end as a base terminal, a second end as a collector terminal, and a third end as an emitter terminal.

Referring to FIG. 7, the constant current unit 42 may include a first amplifier $OP_1$, a first switch $SW_{11}$, and a first-2 switch $SW_{12}$. The opening sensing unit 420 may include a second amplifier $OP_2$, a second-1 switch $SW_{21}$, and a second-2 switch $SW_{22}$. Further, the short sensing unit 430 may include a third amplifier $OP_3$, a third-1 switch $SW_{31}$, and a third-2 switch $SW_{32}$. The switches of the opening sensing unit 420 are opening sensing switches that operate according to an open state of the ultraviolet LED 11. Further, the switches of the short sensing unit 430 are short sensing switches that operate according to a short state of the ultraviolet LED 11.

Each of the first amplifier $OP_1$, the second amplifier $OP_2$, and the third amplifier $OP_3$ may compare an input voltage with a corresponding preset reference voltage and may output signals that turn on or turn off switches connected thereto depending upon a comparison result.

A fifth resistor $R_5$ and a sixth resistor $R_6$ are connected in series to the cathode terminal of the ultraviolet LED 11. The first amplifier $OP_1$ of the constant current unit 42 may be connected to a first node (Node 1) to which the fifth resistor $R_5$

and the sixth resistor $R_6$ are connected and may receive a first node voltage. The first node voltage is a voltage at the first node. The first amplifier $OP_1$ may compare the first node voltage with a preset reference voltage $V_{ref1}$ and may output a signal to control the first-1 switch $SW_{11}$. Here, the signal controlling the first-1 switch $SW_{11}$ may be a voltage input to the first end, which is the base terminal of the first-1 switch $SW_{11}$. When the first switch $SW_{11}$ is turned on to increase a current flowing through the first resistor $R_1$, the voltage input to the first end of the second switch $SW_{12}$ increases. When the voltage input to the first end of the first-2 switch $SW_{12}$ is greater than or equal to the operation voltage, the first-2 switch $SW_{12}$ may also be turned on.

As such, the first amplifier $OP_1$ of the constant current unit 42 may control operation of the first-1 switch $SW_{11}$ and the first-2 switch $SW_{12}$ according to a result of comparing the first node voltage with the reference voltage $V_{ref1}$. In addition, the current flowing in the ultraviolet LED 11 may be controlled to be constant by controlling operation of the fourth switch $SW_4$ of the switch unit 46 according to operation of the constant current unit 42.

The second amplifier $OP_2$ of the opening sensing unit 420 may compare a second node voltage at a second node (Node 2), to which the cathode terminal of the ultraviolet LED 11 and the fifth resistor $R_5$ are connected, with a reference voltage $V_{ref2}$, and may control operation of the second-1 switch $SW_{21}$ and the second-2 switch $SW_{22}$ according to a comparison result. Here, the second node voltage is a voltage applied to the second node.

In addition, the third amplifier $OP_3$ of the short sensing unit 430 may compare a third node voltage of a third node (Node 3), to which an eighth resistor $R_8$ and a ninth resistor $R_9$ are connected, with a reference voltage $V_{ref3}$, and may control operation of the third-1 switch $SW_{31}$ and the third-2 switch $SW_{32}$ according to a comparison result. Here, the third node voltage is a voltage applied to the third node.

When the ultraviolet LED 11 is in a normal state, input voltages to the second amplifier $OP_2$ of the opening sensing unit 420 and the third amplifier $OP_3$ of the short sensing unit 430 may be higher than the reference voltages thereof.

Here, since the input voltage to the second amplifier $OP_2$ is higher than the reference voltage $V_{ref2}$, the second amplifier $OP_2$ may output a lower voltage than the operation voltage of the second-1 switch $SW_{21}$ as a control signal to the second-2 switch $SW_{21}$. Upon receiving the control signal from the second amplifier $OP_2$, the second-1 switch $SW_{21}$ is kept in a turn-off state and thus the second-2 switch $SW_{22}$ is also kept in a turn-off state. Accordingly, when the ultraviolet LED 11 is in a normal state, the opening sensing unit 420 may be in an inactive state.

Furthermore, since the input voltage to the third amplifier $OP_3$ is higher than the reference voltage $V_{ref3}$, the third amplifier $OP_3$ may output a lower voltage than the operation voltage of the third-1 switch $SW_{31}$ as a control signal to the third-1 switch $SW_{31}$. Upon receiving the control signal from the third amplifier $OP_3$, the third-1 switch $SW_{31}$ is kept in a turn-off state and thus the third-3 switch $SW_{33}$ is also kept in a turn-off state. Accordingly, when the ultraviolet LED 11 is in a normal state, the short sensing unit 430 may be in an inactive state.

As such, when the ultraviolet LED 11 is in a normal state, the fault signal output terminal 17 may output a normal signal, which is a voltage indicating that the ultraviolet LED 11 is in the normal state. Here, the magnitude of the normal signal may be preset. For example, the voltage corresponding to the normal signal may be set using the constant voltage characteristics of a Zener diode 49. That is, a Zener voltage of the Zener diode 49 may be output when the ultraviolet LED 11 is in the normal state. Here, the Zener voltage of the Zener diode 49 may have a difference distinguishable from the voltage output from the fault signal output terminal 17 when the ultraviolet LED 11 is in an open state or in a short state.

When the ultraviolet LED 11 is in a short state, the first node voltage is higher than the reference voltage $V_{ref2}$ of the second amplifier $OP_2$. Here, the second-1 switch $SW_{21}$ may be kept in a turn-off state by a signal output from the second amplifier $OP_2$. In addition, the second switch $SW_{22}$ may also be kept in a turn-off state. That is, when the ultraviolet LED 11 is in a short state, the opening sensing unit 420 may be in an inactive state.

Here, the third node voltage may be set to be less than or equal to the reference voltage $V_{ref3}$ of the third amplifier $OP_3$ by the eighth resistor $R_8$ and the ninth resistor $R_9$. Furthermore, when the ultraviolet LED 11 is in a short state, the third node voltage may be maintained at a preset voltage by a feedback system of the third amplifier $OP_3$. Here, the preset voltage may be the same as the reference voltage $V_{ref3}$.

The third amplifier $OP_3$ may output a signal that turns on the third-1 switch $SW_{31}$. Upon receiving the signal from the third amplifier $OP_3$, the third-1 switch $SW_{31}$ may be turned on and thus the third-2 switch $SW_{32}$ may also be turned on. As the third-2 switch $SW_{32}$ is turned on, a current flowing in the fourth node (Node 4), to which the seventh resistor $R_7$ and the Zener diode 49 are connected, flows through the third-2 switch $SW_{32}$.

Accordingly, when the ultraviolet LED 11 is in a short state, the fault signal output terminal 17 may output a voltage corresponding to a fault signal $V_{fault}$, as calculated according to Equation 2.

[Equation 2]

$$V_{fault} = V_{CE32} + V_{ref3}$$

Here, $V_{CE32}$ denotes $V_{CE}$ of the third-2 switch $SW_{32}$.

Further, when the ultraviolet LED 11 is in a short state, the first node voltage and the third node voltage, which are the input voltages of the first amplifier $OP_1$ and the third amplifier $OP_3$, may be maintained at a preset voltage value by the feedback system of the first amplifier $OP_1$ and the second amplifier $OP_2$. For example, the preset voltage may be the same as the reference voltage of each amplifier.

When the ultraviolet LED 11 is in a short state, the third node voltage is set to be equal to the reference voltage $V_{ref3}$ of the third amplifier $OP_3$ and $V_{CE32}$ is also a voltage with a very small magnitude. Therefore, when the ultraviolet LED 11 is in a short state, a slightly higher voltage than the third node voltage may be output as a fault signal to the fault signal output terminal 17.

When the ultraviolet LED 11 is in an open state, the third node voltage may be higher than the reference voltage $V_{ref3}$ of the third amplifier $OP_3$. Here, the third switch $SW_{31}$ may be turned off by a signal output from the third amplifier $OP_3$ and thus the third switch $SW_{32}$ may also be turned off. Accordingly, the short sensing unit 430 may be in an inactive state.

When the ultraviolet LED 11 is in an open state, the third node voltage $V_{node3}$ may be calculated according to Equation 3.

$$[\text{Equation 3}]$$

$$V_{node3} = V_{IN} \cdot (R_9/(R_8+R_9))$$

In addition, when the ultraviolet LED 11 is in an open state, the first node voltage may be lower than the reference voltage $V_{ref2}$ of the second amplifier $OP_2$. The second node voltage $V_{node2}$ may be calculated according to Equation 4.

$$[\text{Equation 4}]$$

$$V_{node2} = (V_{ref1}/R_6) \cdot (R_5+R_6)$$

For example, when the ultraviolet LED 11 is in an open state, the first node voltage may be 0 V or a low voltage close to 0 V.

Upon receiving the first node voltage as an input voltage, the second amplifier $OP_2$ may output a signal that turns on the second-1 switch $SW_{21}$. Thus, the second-1 switch $SW_{21}$ and the second-2 switch $SW_{22}$ may also be sequentially turned on. When the second-2 switch $SW_{22}$ is turned on, the current may be rerouted to pass through the second-2 switch $SW_{22}$.

Here, when the ultraviolet LED 11 is in an open state, the fault signal output terminal 17 may output a voltage corresponding to a fault signal $V_{fault}$, as calculated according to Equation 5.

$$[\text{Equation 5}]$$

$$V_{fault} = V_{node2} + V_{CE22}$$

Here, $V_{CE22}$ is $V_{CE}$ of the second-2 switch $SW_{22}$.

When the ultraviolet LED 11 is in an open state, $V_{node2}$ is 0 V or a very low voltage close to 0 V and $V_{CE22}$ is also a very low voltage. Accordingly, when the ultraviolet LED 11 is in an open state, a very low voltage close to 0 V may be output as a fault signal from the fault signal output terminal 17.

According to this embodiment, when the ultraviolet LED 11 is in a faulty state as in a short state or in an open state, the fault signal output from the fault signal output terminal 17 may be a lower voltage than when the ultraviolet LED 11 is in a normal state. For example, when the ultraviolet LED 11 is in a faulty state, the fault signal output terminal 17 may output a smaller voltage than the Zener voltage of the Zener diode 49.

As such, the LED driving module 40 according to this embodiment may output a preset voltage, such as a Zener voltage, through the fault signal output terminal 17 when the ultraviolet LED 11 is in a normal state, and may output a lower voltage than the Zener voltage through the fault signal output terminal 17 when the ultraviolet LED 11 is in an abnormal state. Accordingly, the state of the ultraviolet LED 11 may be determined according to the magnitude of the output voltage of the LED driving circuit according to this embodiment.

The LED driving module 40 according to this embodiment applies an amplifier to each of the opening sensing unit 420 and the short sensing unit 430 and uses a reference voltage within the amplifier to sense a short state and an open state of the ultraviolet LED 11. The LED driving module 40 according to this embodiment employs an amplifier with a small deviation due to a surrounding environment, such as temperature change, thereby minimizing deviation of an output voltage due to change in surrounding environment. Accordingly, the LED driving module 40 according to this embodiment can prevent an error of incorrectly determining failure of the LED driving module 40 by minimizing the deviation of the voltage to be used to determine the fault of the ultraviolet LED 11.

In this embodiment, the fourth switch $SW_4$ of the switch unit 46 is described as a P-type MOSFET by way of example. However, it should be understood that the type of the fourth switch $SW_4$ is not limited thereto. The fourth switch $SW_4$ of the switch unit 46 can be any device capable of being turned on and off according to an input value. In addition, the switches of the constant current unit 42, the opening sensing unit 420, and the short sensing unit 430 may be any devices capable of being turned on and off according to input signals.

Further, the LED driving module 40 according to this embodiment may further include a heat sensing unit as described in the LED driving module according to the above embodiments.

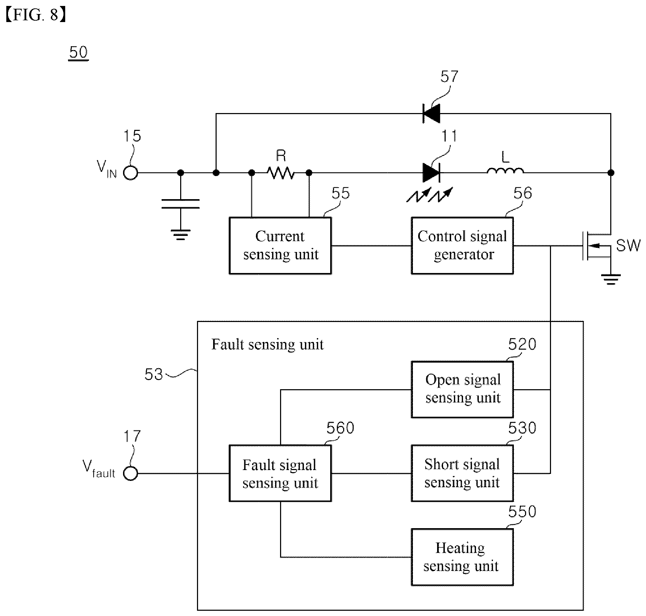

FIG. 8 is a block diagram of an LED driving module according to a fifth embodiment of the present invention.

Referring to FIG. 8, the LED driving module 50 according to the fifth embodiment of the present invention may include a current sensing unit 55, a control signal generator 56, and a fault sensing unit 53.

The current sensing unit 55 may sense a current supplied to the ultraviolet LED 11.

The control signal generator 56 may generate a control signal to control a switch SW according to the current sensed by the current sensing unit 55. The control signal generator 56 may generate a short signal that turns on the switch SW and an open signal that turns off the switch SW.

The switch SW may be turned on or turned off according to a control signal received from the control signal generator 56. When the switch SW is turned off in response to the open signal, a current may flow along a node to which an ultraviolet LED 11, an inductor L, and a diode 57 are connected. When the switch SW is turned on in response to the short signal, a current may flow along the node to which the ultraviolet LED 11, the inductor L, and the switch SW are connected.

The fault sensing unit 53 may include a heat sensing unit 550, an open signal sensing unit 520, a short signal sensing unit 530, and a fault signal generator 560.

The heat sensing unit 550 according to this embodiment may sense the degree of heating of the ultraviolet LED 11. The heat sensing unit may sense the temperature of the ultraviolet LED 11 or an ambient temperature and may send a signal corresponding to the sensed temperature to the fault signal generator 560. The fault signal generating unit 560 may generate and output a fault signal indicating a fault of the ultraviolet LED 11 in response to the signal received from the heat sensing unit 550. For example, the fault signal generator 560 may generate and output a fault signal when the temperature sensed by the heat sensing unit 550 is higher than or equal to a predetermined temperature.

The open signal sensing unit 520 and the short signal sensing unit 530 may sense a control signal sent from the control signal generator 56 to the switch SW.

The open signal sensing unit 520 may sense an open signal that the control signal generator 56 sends to the switch SW.

For example, when the ultraviolet LED 11 is in a short state, a current continuously flows in a node to which the current sensing unit 55 is connected. That is, a current having a certain magnitude may be continuously sensed by the current sensing unit 55. Here, the control signal generator 56 may generate and send an open signal to the switch SW while the current sensing unit 55 senses the current having an arbitrary magnitude.

The open signal sensing unit 520 may sense the open signal from the control signal generator 56 and may send a corresponding signal to the fault signal generator 560. Here, the fault signal generator 560 may determine that the ultraviolet LED 11 is in a short state when the open signal sensing unit 520 senses the open signal for a preset period of time or more. Accordingly, the fault signal generator 560 may generate and output a fault signal indicating a fault of the ultraviolet LED 11 when the control signal generator 56 generates the open signal for a preset period of time or more.

The short signal sensing unit 530 may sense a short signal that the control signal generator 56 sends to the switch SW.

For example, when the ultraviolet LED 11 is in an open state, no current flows in the node to which the current sensing unit 55 is connected. Here, the control signal generator 56 may generate and send a short signal to the switch SW in order to allow a current to flow to the ultraviolet LED 11. However, since the ultraviolet LED 11 is in the open state, the current sensing unit 55 cannot sense the current even when the switch SW is in a short state. Accordingly, the control signal generator 56 continuously generates and transmits the short signal to the switch SW.

The short signal sensing unit 530 may sense the short signal from the control signal generator 56 and may send a corresponding signal to the fault signal generator 560. Here, the fault signal generator 560 may determine that the ultraviolet LED 11 is in an open state when the short signal sensing unit 530 senses the short signal for a preset period of time or more. Accordingly, the fault signal generator 560 may generate and output a fault signal indicating a fault of the ultraviolet LED 11 when the control signal generator 56 generates the short signal for a preset period of time or more.

As such, the LED driving module 50 according to this embodiment may sense a control signal of the control signal generator 56, which controls the switch SW, and may sense a fault of the ultraviolet LED 11 based on the type of control signal and a period of time for which the control signal is sent to the switch SW.

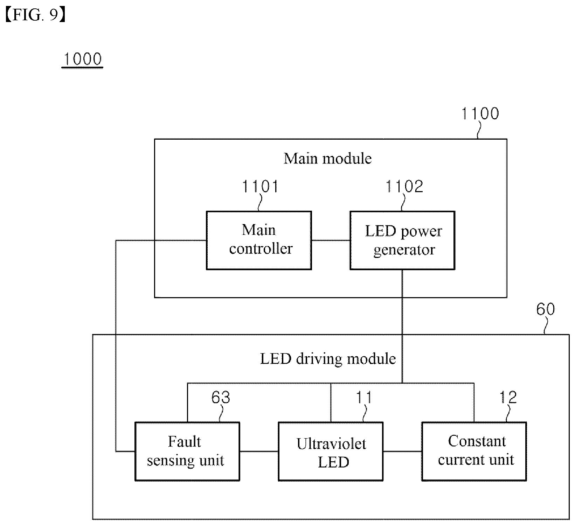

FIG. 9 is a schematic block diagram of a system of an ultraviolet LED device according to an embodiment of the present invention.

Referring to FIG. 9, a system 1000 of an ultraviolet LED device according to one embodiment may include a main module 1100 and an LED driving module 60.

The main module 1100 may be configured to control an overall operation of a product to which the ultraviolet LED 11 and the LED driving module 60 are applied.

In the system 1000 of the ultraviolet LED device according to this embodiment, the main module 1100 may include a main controller 1101 and an LED power generator 1102.

The main controller 1101 may control the overall operation of the product. The main controller 1101 may generate signals for various operations of the product. In addition, the main controller 1101 may supply power for operation of the components of the product to each component. Furthermore, the main controller 1101 may supply power to the LED power generator 1102.

The LED power generator 1102 may generate LED driving power for operation of the ultraviolet LED 11 and the LED driving module 60. For example, the LED power generator 1102 may convert alternating current power supplied from the main controller 1101 into direct current power to generate the LED driving power. The LED power generator 1102 may also include a filter to block noise, a power factor correction circuit configured to correct a power factor of a power source, and the like.

The driving power generated by the LED power generator 1102 may be supplied to the LED driving module 60.

The LED driving module 60 according to this embodiment may be any of the LED driving modules 10, 20, 30, 40, 50 according to the first to fifth embodiments described with reference to FIG. 1 to FIG. 8.

The LED driving module 60 may supply the driving power received from the LED power generator 1102 to the ultraviolet LED 11 to allow the ultraviolet LED 11 to emit UV light. In addition, the LED driving module 60 may supply the driving power to other components in addition to the ultraviolet LED 11.

The LED driving module 60 may include a constant current unit 12 for stable driving of the ultraviolet LED 11 and a fault sensing unit 63 configured to sense a fault of the ultraviolet LED 11.

The fault sensing unit 63 may generate and send a fault signal, indicating that a fault, such as overheating, short, or opening of the ultraviolet LED 11, has occurred in the ultraviolet LED 11, to the main controller 1101.

When the main controller 1101 receives a fault signal from the fault sensing unit 63, the main controller 1101 may output a corresponding signal such that the signal can be visually or audibly confirmed outside the product. For example, the main controller 1101 may indicate a fault of the ultraviolet LED 11 through a display device provided to the product. In addition, the main controller 1101 may output an audible sound through a speaker installed in the product to indicate the fault of the ultraviolet LED 11.

For example, the LED driving module 60 according to this embodiment may be the LED driving module 20 according to the second embodiment shown in FIG. 5. The fault sensing unit 63 of the LED driving module 60 may send each of the signals output through the first to third fault signal output terminals 27, 28, 29 (see FIG. 5) to the main controller 1101.

The main controller 1101 may determine the state of the ultraviolet LED 11 by combining the signals received from the first to third fault signal output terminals 27, 28, 29 (see FIG. 5) of the fault sensing unit 63, respectively. For example, the main controller 1101 may determine whether the ultraviolet LED 11 undergoes any one of abnormal heating, short, and opening or combinations thereof.

The main controller 1101 may output a signal corresponding to the results of the output terminals of the fault sensing unit 63 to the outside of the product through a device in the product such that the fault of the ultraviolet LED 11 can be visually or audibly recognized outside the product.

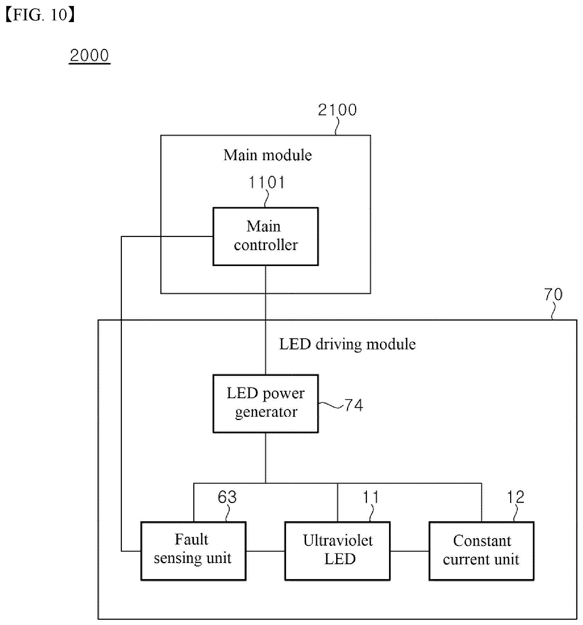

FIG. 10 is a block diagram of a system of an ultraviolet LED device according to another embodiment of the present invention.

The system 2000 of the ultraviolet LED device according to this embodiment may include a main module 2100 and an LED driving module 70.

The system 2000 of the ultraviolet LED device according to this embodiment is different from the system 1000 of the ultraviolet LED device shown in FIG. 9 in that the LED driving module 70 includes an LED power generator 74.

The LED driving module 70 according to this embodiment may convert alternating current power supplied from the main controller 1101 into direct current power. That is, the LED driving module 70 according to this embodiment may include the LED power generator 74. The LED power generator 74 of the LED driving module 70 may convert the power supplied from the main controller 1101 of the main module 2100 into drive power for operation of the ultraviolet LED 11 and other components.

The other components of the LED device system 2000 according to this embodiment are the same as those of the ultraviolet LED device system 1000 shown in FIG. 9 except that the LED driving module 70 includes the LED power generator 74.

The LED driving modules described above in various embodiments of the present invention may be applied to small products each provided with a single ultraviolet LED.

The LED driving module according to the embodiments of the present invention may include the fault sensing unit capable of detecting faults in the ultraviolet LED. Accordingly, the LED driving module may sense various faults that can occur in the ultraviolet LED, and may further generate a signal enabling determination of a detailed kind of fault.

In addition, according to the embodiments of the present invention, the LED driving module can realize the fault sensing unit through a simple circuit, thereby minimizing increase in size of the LED driving module. Thus, the LED driving module according to the embodiments of the invention may generate a signal indicating a fault of the ultraviolet LED while maintaining a size suitable for small products.

Although some embodiments have been described herein with reference to the accompanying drawings, it should be understood that the above embodiments are provided for illustration only and are not to be in any way construed as limiting the present invention. The scope of the present invention should be defined by the appended claims and equivalents thereto.

**Claims**

1. An LED driving module provided with a single ultraviolet LED, comprising:

   a fault sensing unit configured to sense a fault in the ultraviolet LED,
   wherein the fault sensing unit comprises a connection sensing unit configured to sense a connection state of the ultraviolet LED,
   the connection sensing unit being configured to output a fault signal through a fault signal output terminal when a fault occurs due to short or opening of the ultraviolet LED.

2. The LED driving module according to claim 1, wherein
   the connection sensing unit comprises a connection sensing switch turned on and turned off according to a voltage of a node connected to the ultraviolet LED.

3. The LED driving module according to claim 2, wherein

   the node connected to the ultraviolet LED is connected to an anode terminal of the ultraviolet LED, and
   the connection sensing switch comprises:

   a first end to which a voltage corresponding to the node voltage is applied to turn on and turn off the connection sensing switch;
   a second end connected to the fault signal output terminal; and
   a third end connected to ground.

4. The LED driving module according to claim 3, wherein
   the fault signal output terminal comprises:

   a first fault signal output terminal outputting a first fault signal when the ultraviolet LED is in a short state; and
   a second fault signal output terminal outputting a second fault signal when the ultraviolet LED is in an open state.

5. The LED driving module according to claim 4, wherein

   the first fault signal output terminal is connected to a node connecting the second end of the connection sensing switch to one end of a resistor,
   the second fault signal output terminal is connected to a node connecting two resistors in series between the anode terminal of the ultraviolet LED and ground, and
   the resistor connected to the second end of the connection sensing switch is connected at the other end thereof to ground.

6. The LED driving module according to claim 3, wherein
   the fault sensing unit further comprises a heat sensing unit configured to sense a heating state of the ultraviolet LED.

7. The LED driving module according to claim 6, wherein

   the heat sensing unit comprises: a thermal resistor whose resistance varies depending upon ambient temperature; and a heat sensing switch connected to the thermal resistor,
   the thermal resistor being connected to the anode terminal of the ultraviolet LED,
   the heat sensing switch being turned on and turned off in response to a voltage varying according to resistance of the thermal resistor.

8. The LED driving module according to claim 7, wherein
the heat sensing switch comprises:

a first end receiving a voltage varying according to resistance of the thermal resistor;
a second end connected to the fault signal output terminal; and
a third end connected to ground.

9. The LED driving module according to claim 8, wherein
the fault signal output terminal comprises:

a first fault signal output terminal outputting a first fault signal when the ultraviolet LED is in a short state;
a second fault signal output terminal outputting a second fault signal when the ultraviolet LED is in an open state; and
a third fault signal output terminal outputting a third fault signal when the ultraviolet LED is in an overheating state.

10. The LED driving module according to claim 9, wherein

the first fault signal output terminal is connected to a node connecting the second end of the connection sensing switch and one end of a resistor,
the second fault signal output terminal is connected to a node connecting two resistors in series between the anode terminal of the ultraviolet LED and ground,
the third fault signal output terminal is connected to a node connecting the second end of the heat sensing switch to one end of a resistor, and
each of the resistor connected to the second end of the connection sensing switch and the resistor connected to the second end of the heat sensing switch is connected at the other end thereof to ground.

11. The LED driving module according to claim 2, wherein
the connection sensing unit comprises:

an opening sensing unit configured to sense an open state of the ultraviolet LED; and
a short sensing unit configured to sense a short state of the ultraviolet LED.

12. The LED driving module according to claim 11, wherein
each of the opening sensing unit and the short sensing unit comprises:

an amplifier configured to compare a reference voltage with an input voltage; and
at least a switch turned on and turned off by an output signal of the amplifier.

13. The LED driving module according to claim 12, wherein

the opening sensing unit comprises an opening sensing switch,
the opening sensing switch comprising:

a first end receiving a voltage for turning on and turning off the switch in response to a signal output from the amplifier of the opening sensing unit;
a second end connected to the fault signal output terminal; and
a third end through which a current input through the first end passes when the opening sensing switch is in a turn-on state.

14. The LED driving module according to claim 12, wherein

the short sensing unit comprises a short sensing switch,
the short sensing switch comprising:

a first end receiving a voltage for turning on and turning off the switch in response to a signal output from the amplifier of the short sensing unit;

a second end connected to the fault signal output terminal; and
a third end through which a current input through the first end passes when the short sensing switch is in a turn-on state.

15. The LED driving module according to claim 11, wherein
the fault signal output terminal outputs a normal signal when the ultraviolet LED is in a normal state.

16. The LED driving module according to claim 15, wherein
the fault signal is a lower voltage than the normal signal.

17. The LED driving module according to claim 15, further comprising:

a Zener diode connected at one end thereof to the fault signal output terminal and at the other end thereof to ground,
wherein the normal signal is a Zener voltage.

18. The LED driving module according to claim 1, further comprising:

a current sensing unit configured to sense a current supplied to the ultraviolet LED; and
a control signal generator configured to generate and output a signal to control a switch according to the current sensed by the current sensing unit;
wherein the control signal generator outputs a short signal and an open signal to the switch, the short signal turning on the switch, the open signal turning off the switch,
the connection sensing unit senses the short signal and the open signal output from the control signal generator to the switch, and
the fault sensing unit generates and outputs a fault signal when the short signal or the open signal sensed by the connection sensing unit is sensed for a preset period of time or more.

19. The LED driving module according to claim 18, wherein

the fault sensing unit further comprises a heat sensing unit configured to sense a temperature of the ultraviolet LED or an ambient temperature of the ultraviolet LED, and
the fault sensing unit generates and outputs a fault signal when the temperature sensed by the heat sensing unit is greater than or equal to a preset temperature.

20. The LED driving module according to claim 1, further comprising:
a constant current unit configured to supply a constant current to the ultraviolet LED.

【FIG. 1】

【FIG. 2】

<u>10</u>

【FIG. 3】

【FIG. 4】

【FIG. 5】

【FIG. 6】

【FIG. 7】

【FIG. 8】

50

【FIG. 9】

1000

Main module 1100

Main controller 1101

LED power generator 1102

LED driving module 60

Fault sensing unit 63

Ultraviolet LED 11

Constant current unit 12

【FIG. 10】

2000

## INTERNATIONAL SEARCH REPORT

| International application No. |
| --- |
| **PCT/KR2023/010579** |

| A. | CLASSIFICATION OF SUBJECT MATTER |
| --- | --- |

**H05B 45/50**(2020.01)i; **H05B 45/345**(2020.01)i

According to International Patent Classification (IPC) or to both national classification and IPC

| B. | FIELDS SEARCHED |
| --- | --- |

Minimum documentation searched (classification system followed by classification symbols)

H05B 45/50(2020.01); G01R 31/26(2006.01); G09G 3/14(2006.01); H05B 33/08(2006.01); H05B 37/02(2006.01); H05B 37/03(2006.01); H05B 45/00(2020.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 엘이디 구동 모듈(LED driving module), 불량 감지(fault detection), 개방 (open), 단락(short)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2014-0092315 A (ADVANCED ANALOGIC TECHNOLOGIES, INC.) 23 July 2014 (2014-07-23) See paragraphs [0049]-[0052] and [0061]-[0062]; claims 9-10; and figures 3a and 6. | 1,18-20 |
| Y | | 2,11-12,15-17 |
| A | | 3-10,13-14 |
| Y | KR 10-2011-0028204 A (IWATT INC.) 17 March 2011 (2011-03-17) See paragraphs [0071]-[0076]; and figure 9. | 2,11-12,15-17 |
| A | KR 10-2017-0032405 A (OSRAM OLED GMBH) 22 March 2017 (2017-03-22) See paragraphs [0044]-[0160]; and figures 1-12. | 1-20 |
| A | KR 10-2012-0003793 A (INSTITUTE FOR INFORMATION INDUSTRY) 11 January 2012 (2012-01-11) See paragraphs [0020]-[0064]; and figures 1-2. | 1-20 |

| ✓ | Further documents are listed in the continuation of Box C. | | ✓ | See patent family annex. |
| --- | --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **30 October 2023** | **30 October 2023** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2023/010579**

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2020-0045671 A (YOONJIN ELECTRONICS CO., LTD.) 06 May 2020 (2020-05-06) See paragraphs [0017]-[0039]; and figures 2-5. | 1-20 |

Form PCT/ISA/210 (second sheet) (July 2022)

**INTERNATIONAL SEARCH REPORT**
Information on patent family members

International application No.

**PCT/KR2023/010579**

| Patent document cited in search report | | | Publication date (day/month/year) | Patent family member(s) | | | Publication date (day/month/year) |
|---|---|---|---|---|---|---|---|
| KR | 10-2014-0092315 | A | 23 July 2014 | CN | 104011783 | A | 27 August 2014 |
| | | | | CN | 104011783 | B | 25 August 2017 |
| | | | | CN | 104115564 | A | 22 October 2014 |
| | | | | EP | 2771876 | A1 | 03 September 2014 |
| | | | | KR | 10-1099991 | B1 | 28 December 2011 |
| | | | | KR | 10-2014-0102284 | A | 21 August 2014 |
| | | | | US | 2013-0082604 | A1 | 04 April 2013 |
| | | | | US | 2013-0082609 | A1 | 04 April 2013 |
| | | | | US | 2013-0082614 | A1 | 04 April 2013 |
| | | | | US | 2013-0082615 | A1 | 04 April 2013 |
| | | | | US | 2013-0099681 | A1 | 25 April 2013 |
| | | | | US | 2013-0099682 | A1 | 25 April 2013 |
| | | | | US | 2013-0099701 | A1 | 25 April 2013 |
| | | | | US | 9220139 | B2 | 22 December 2015 |
| | | | | US | 9232587 | B2 | 05 January 2016 |
| | | | | US | 9288861 | B2 | 15 March 2016 |
| | | | | US | 9295123 | B2 | 22 March 2016 |
| | | | | US | 9351364 | B2 | 24 May 2016 |
| | | | | WO | 2013-049524 | A1 | 04 April 2013 |
| | | | | WO | 2013-062957 | A1 | 02 May 2013 |
| | | | | WO | 2013-086154 | A1 | 13 June 2013 |
| KR | 10-2011-0028204 | A | 17 March 2011 | CN | 102026442 | A | 20 April 2011 |
| | | | | CN | 102026442 | B | 09 July 2014 |
| | | | | KR | 10-2012994 | B1 | 21 August 2019 |
| | | | | US | 2011-0062872 | A1 | 17 March 2011 |
| | | | | US | 2013-0127344 | A1 | 23 May 2013 |
| | | | | US | 8334662 | B2 | 18 December 2012 |
| | | | | US | 9451664 | B2 | 20 September 2016 |
| KR | 10-2017-0032405 | A | 22 March 2017 | CN | 106574944 | A | 19 April 2017 |
| | | | | CN | 106574944 | B | 12 July 2019 |
| | | | | KR | 10-2009581 | B1 | 09 August 2019 |
| | | | | US | 10578665 | B2 | 03 March 2020 |
| | | | | US | 2017-0269146 | A1 | 21 September 2017 |
| | | | | WO | 2016-030081 | A1 | 03 March 2016 |
| KR | 10-2012-0003793 | A | 11 January 2012 | KR | 10-1208091 | B1 | 04 December 2012 |
| | | | | US | 2012-0001552 | A1 | 05 January 2012 |
| KR | 10-2020-0045671 | A | 06 May 2020 | KR | 10-2109045 | B1 | 12 May 2020 |

Form PCT/ISA/210 (patent family annex) (July 2022)